# EUROPEAN PATENT APPLICATION

(11) **EP 3 079 014 A2**
(43) Date of publication of application: **12.10.2016**
(21) Application number: 16162738.5
(22) Date of filing: 30.03.2016
(51) Int. Cl.: G03F 1/64

(54) **AN EUV PELLICLE FRAME AND AN EUV PELLICLE USING IT**

(30) Priority: 07.04.2015 JP 2015078209
(71) Applicant: Shin-Etsu Chemical Co., Ltd., Chiyoda-ku Tokyo (JP)
(72) Inventor: HORIKOSHI, Jun, Gunma-Ken (JP)
(74) Representative: Cabinet Armengaud Aîné

(57) **Abstract**

An EUV pellicle is proposed in which the pellicle frame is made of a material having a linear expansion coefficient of 10 x 10⁻⁶ (1/K) or smaller, and as such this pellicle is recommendable for use in EUV exposure technology wherein temperature is raised and lowered repeatedly and hence the expansion and contraction of the pellicle frame would harm the pellicle membrane and the pellicle flatness.

## Description

The present non-provisional patent application claims priority, as per Paris Convention, from Japanese Patent Application No. 2015-78209 filed on 2015-4-7th, the disclosure of which is incorporated by reference herein in its entirety.

### [Field of the Invention]

The present invention relates to a pellicle for lithography, useful as a dust-fender employed in the scenes of manufacturing semiconductor devices such as LSI and super-LSI, a printed circuit board, or a liquid crystal display panel or the like; and more particularly the invention relates to a pellicle which uses a pellicle frame having a low linear expansion coefficient, which is suitable to a lithography operation wherein an extremely short wave length light is used to obtain highly fine (micro-precision) circuit pattern.

### [Background Technology]

In manufacturing semiconductor devices such as LSI and super-LSI or in manufacturing a liquid crystal display panel or the like, a circuit pattern is made by irradiating a light to a semiconductor wafer or a negative plate for liquid crystal, but problems occur if a dust particle is sticking to a photographic mask or a reticle (hereinafter these are simply referred to as "photomask") used in this stage; for then the pattern's edges become blurred and what is more the under base gets smeared in black, whereby the dimension, quality, appearance, and other aspects of the resulting product are degraded.

Thus, these works are usually performed in a clean room, but, even in a clean room, it is yet difficult to keep the photomask clean all the time. Hence, the exposure light irradiation is conducted only after a pattern-bearing part of the surface of the photomask is sheltered by a pellicle as a dust fender. Under such circumstances, foreign particles do not directly adhere to the surface of the photomask, but only onto the pellicle membrane, and thus by setting the focus to occur at a pattern on the photomask at the time of lithographing, the foreign particles on the pellicle membrane do not affect the transferred image of the pattern.

In general, a pellicle is made in a manner such that a transparent pellicle membrane made of cellulose nitrate, cellulose acetate, a fluorine-containing polymer or the like, which transmit light well, is adhered to an upper annular face of a pellicle frame, which is made of an aluminum, a stainless steel, polyethylene or the like, after applying to the upper annular face a solvent which dissolves the pellicle membrane well, and then by drying the solvent by blown air (ref. IP Publication 1), or after applying to the upper annular face an adhesive made of a material such as an acrylic resin or an epoxy resin (ref. IP Publications 2, 3). Further, on a lower annular face of the pellicle frame is laid an agglutinant layer made of a polybutene resin, a polyvinyl acetate resin, an acrylic resin, a silicone resin or the like for attaching the pellicle frame to the photomask, and over this agglutinant layer is laid a releasable liner (separator) for protecting the agglutinant layer.

A pellicle such as this is adhered to a surface of a photomask and then a photoresist film formed on a semiconductor wafer or on a negative plate for liquid crystal is exposed to the light coming through the photomask film; on this occasion, as described above, foreign particles, if any, are not directly adhering to the surface of the photomask, but only to the pellicle membrane, so that by arranging the lithographic light to focus at the pattern on the photomask, the foreign particles on the pellicle membrane fail to affect the image of the pattern transferred on the photomask.

In recent years, the semiconductor devices and liquid crystal displays have progressed to have yet higher integration and refinement in their circuit patterns. Currently, the technology for forming an about 32-nm-fine micro pattern on a photoresist film is becoming practical. In the case of about 32-nm-fine pattern, it is possible to answer the requirements with improved versions of conventional excimer laser technologies such as the double exposure method and the liquid immersion exposure method, wherein the space between the semiconductor wafer or liquid crystal display panel and the projector lens is filled with super pure water or the like, and argon fluoride (ArF) excimer laser is used for irradiation to thereby expose the photoresist film to the light.

However, the next-generation semiconductor devices and liquid crystal displays are required to carry more refined patterns, such as 10-nm-fine or even finer, and it would be impossible to transform such patterns with any technology that may arise from improvement of the conventional exposure technologies which use excimer laser.

Now, as a most promising method for forming a pattern of a refinement degree of 10 nm or finer, an EUV (Extreme Ultra Violet) exposure technology which uses an EUV light of a dominant wavelength of 13.5mm is in the spotlight. To achieve a pattern formation of a refinement degree of 10 nm or finer on the photoresist film, it is necessary to solve the technical problems with regard to the choices of light source, photoresist, pellicle, etc., and in respect of the light source and the photoresist there have been considerable progresses and various porposals have been made.

With respect to the pellicle that improves yields of semiconducor divice products or liquid crystal displays, IP Publication 3 discloses a silicon film of a thickness of 0.1 - 2.0 micrometers to act as a pellcile film for EUV lithography which is transparent and does not give rise to optical distortion; however there remain problems unsolved yet which still thwart realization of the EUV light exposure technology.

### [Prior Art Publications]

### [IP Publications]

[IP Publication 1]
   Japanese Patent Application Publicatin S58[1983]-219023
[IP Publication 2]
   United States Patent No. 4861402
[IP Publication 3]
   Japanese Pre-Patent Publication for Public Review S63[1988]-27707

### [Summary of the Invention]

### [Problems the Invention seeks to solve]

In respect of the material to make the pellicle frame, which supports the pellicle membrane, the selection has been made solely based on the rigidity and workability of the material, in the case of conventional lithography where the exposure lights used were i-line (wavelength of 365 nm), krypton fluoride (KrF) excimer laser (wavelength of 248 nm), or argon fluoride (ArF) excimer laser (wavelength of 193 nm); consequently such materials as aluminum, stainless and polyethylene have been chiefly used.

With regard to the material to make the photomask, quartz glass is normally used; and as for the transparent material to make the pellicle membrane, the selection is made depending on the light source: for example, cellulose nitrate, cellulose acetate, fluorine-containing resin or the like have been used in the case where the exposure light used is i-line, krypton fluoride (KrF) excimer laser, or argon fluoride (ArF) excimer laser, and in the case of EUV, silicon or the like is used.

However, in the case of the EUV exposure light lithography, where a pattern of a fineness order of 10 nm or smaller is printed on the photoresist film, if a conventional pellicle is used the pellicle membrane is apt to wrinkle, peel off the pellicle frame, be torn, or be broken into pieces, or the photomask may be caused to deform.

When the photomask is deformed, the flatness of the photomask is degraded and the exposure equipment may have a problem of defocusing. On the other hand, as the photomask is deformed, the pattern formed on the surface of the photomask undergoes a warping, giving rise to a problem that the image of the pattern that is transferred to the wafer by the light irradiation is deformed.

In order to cope with these problems, there is proposed a method wherein the adhesive to bind the pellicle membrane is designed to have an elasticity. However, even when both the adhesive that binds together the pellicle membrane and the pellicle frame and the adhesive that binds together the photomask and the pellicle frame are elastic, the improvement thus attained does not amount to complete prevention of the pellicle membrane from wrinkling, peeling off the pellicle frame, being torn, or being broken into pieces, nor to prevention of the pattern formed on the photomask from warping.

In view of the above-stated circumstances, it is an object of the present invention to provide a pellicle frame and a pellicle using such pellicle frame which effectively prevent the pellicle membrane from wrinkling, peeling off the pellicle frame, being torn, or being broken into pieces, and also prevent the photomask from deforming during the operation of forming a very fine pattern on the photoresist film, especially in the case of using the EUV exposure technology wherein a pattern of a fineness order of 10 nm or smaller is printed on the photoresist film.

### [Means to solve the problem]

The present inventor tackled the problems with a new procedure, namely for the purpose of preventing the pellicle membrane from wrinkling, peeling off the pellicle frame, being torn, or being broken into pieces, and also for the purpose of preventing the photomask from deforming during the EUV exposure operation wherein a pattern of a fineness order of 10 nm or smaller is printed on the photoresist film, the inventor resorted to the pellicle frame rather than to the aforementioned elastic adhesives; as a result of this new endeavor to solve the problems, the inventor found that, in the case of using the EUV exposure technology wherein a pattern of a fineness order of 10 nm or smaller is printed on the photoresist film, temperature rises significantly due to the high light energy at the time of the light exposure, so that it is not proper to select the material for the pellicle frame based only on the rigidity and workability of the material as had been done conventionally; and he paid attention to linear expansion coefficient, another physical property, and after examining the linear expansion coefficients of the materials to make the pellicle frame, he realized that, when the linear expansion coefficient was within a certain, it was possible to restrict the expansion and deformation of the pellicle frame, which were caused by the temperature rise due to the light energy created at the time of the light exposure operation, and hence with such pellicle frames the abovementioned problems were virtually solved - hence the completion of the invention.

In particular, the EUV pellicle frame according to the present invention is characteristic in that it is made of a material having a linear expansion coefficient of 10 x 10⁻⁶ (1/K) or smaller.

Also, the EUV pellicle frame according to the present invention is preferably made of a metal having a linear expansion coefficient of 10 x 10⁻⁶ (1/K) or smaller.

Also, it is possible that the EUV pellicle frame according to the present invention is made of glass having a linear expansion coefficient of 10 x 10⁻⁶ (1/K) or smaller.

Also, it is possible that the EUV pellicle frame according to the present invention is made of ceramics having a linear expansion coefficient of 10 x 10⁻⁶ (1/K) or smaller.

Further, the present invention also claims an EUV pellicle wherein the EUV pellicle frame is made of a material having a linear expansion coefficient of 10 x 10⁻⁶ (1/K) or smaller.

### [Effects of the Invention]

According to the present invention, an EUV pellicle frame is made of a material having a linear expansion coefficient of 10 x 10⁻⁶ (1/K) or smaller, so that when a fine pattern is printed on the photoresist film, especially when the EUV exposure technology is used to print a pattern of a fineness order of 10 nm or smaller on the photoresist film, it is possible to restrict the expansion and deformation of the pellicle frame, which are caused by the temperature rise due to the light energy created at the time of the light exposure operation, so that it becomes possible to prevent the pellicle membrane from wrinkling, peeling off the pellicle frame, being torn, or being broken into pieces, and also to prevent the pattern formed on the photomask from warping.

### [Brief Descriptions of Drawings]

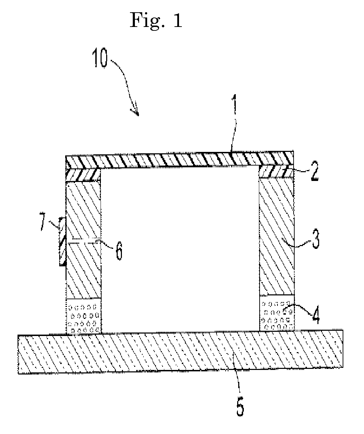

[Fig. 1] A longitudinal cross-sectional view showing an example of the EUV pellicle of the present invention in which the EUV pellicle frame is made of a material having a linear expansion coefficient of 10 x 10⁻⁶ (1/K) or smaller.

### [Examples to embody the Invention]

Now, the present invention will be explained in greater detail with reference to the drawings, and one should not be misled to construe the invention to be limited to the examples or the drawing.

Fig. 1 is a longitudinal cross-sectional view showing an example of the pellicle 10 of the present invention in which the pellicle frame 3 is made of a material having a linear expansion coefficient of 10 x 10⁻⁶ (1/K) or smaller. In this pellicle 10 a pellicle membrane 1 is tensely adhered via an adhesive 2 to an upper annular face of a pellicle frame 3, which has a shape corresponding to the shape of a photomask 5 to which the pellicle 10 is adhered, the shape of the pellicle frame 3 being generally quadrilateral (either rectangular or square). Also, an agglutinant layer 4 is formed on a lower annular face of the pellicle frame 3 for the purpose of enabling the pellicle 10 to adhere to the photomask 5; and a releasing liner (not shown) is detachably adhered to the exposed lower face of the agglutinant layer 4. Also, an air pressure adjustment hole (vent hole) 6 is made through the pellicle frame 3, and a dust stopper filter 7 for prevention of particle contamination is provided to the hole 6.

It is noted that, for the purpose of the present invention, there is no limitation to the material of which the pellicle membrane is made, and it is possible to use, for example, an amorphous fluorine-containing polymer and the like, which have been used along with the conventional excimer laser. Examples of such amorphous fluorine-containing polymer include CYTOP (a commercial product of ASAHI GLASS CO., LTD.) and Teflon™ AF (a commercial product of Du Pont Kabushiki Kaisha) . These polymers may be dissolved in a solvent before they are made into pellicle film, if need be; for example they may be dissolved in a fluorine-containing solvent.

In the case of EUV exposure, the pellicle membrane is preferably made of a material having a high transmittance to EUV light such as single crystal silicon, poly-crystal silicon, and amorphous silicon. It is also possible to provide to the membrane a protective sheet of a material such as SiC, SiO2, Si₃N₄, SiON, Y₂O₃, YN, Mo, Ru, and Rh.

The pellicle frame of the present invention has a linear expansion coefficient of 10 x 10⁻⁶ (1/K) or smaller (at temperatures experienced when EUV exposure is conducted, generally, from 0 to 200 degrees C) so as to minimize the expansion and deformation of the pellicle frame, which are caused as the temperature rises with the EUV exposure operation.

There is no limitation to the material of which the pellicle frame is made, so long as its linear expansion coefficient is 10 x 10⁻⁶ (1/K) or smaller; the material may be, for example, metal, glass, or ceramics. More particularly, it is possible that such material is a metal such as Fe-Ni alloy, Fe-Ni-Co alloy, Fe-Ni-Co-Cr alloy, and Fe-Co-Cr alloy, or a glass such as quartz glass, borosilicate glass, soda-lime glass, aluminoborosilicate glass, aluminosilicate glass, and crystallized glass, or a ceramics such as silicon carbide, silicon nitride, boron nitride, aluminum nitride, and aluminum oxide. These materials can be used singly or in combination of two or more to make the pellicle frame.

When the overall consideration is made based on the effects of the present invention, rigidity, workability and the like, the following among the above-stated materials are preferable: metals such as Invar (Fe-Ni36), Super Invar (Fe-Ni32-Co5), Stainless Invar (Fe-Ni52-Co22-Cr), and Kovar (Fe-Ni29-Co17); glasses such as quartz glass (SiO₂), borosilicate glass (Na₂O-B₂O₃-SiO₂), and soda-lime glass (Na₂O-CaO-SiO₂); and ceramics such as silicon carbide (SiC), silicon nitride (Si₃N₄), boron nitride (BN), aluminum nitride (AlN), aluminum oxide (Al₂O₃); furthermore, Invar, Super Invar, quartz glass, and aluminum oxide are especially preferable.

For reference purpose, the linear expansion coefficients (1/K) of several materials are shown below:

| | |
|---|---|
| Invar: | 1 x 10⁻⁶ |
| Super Invar: | 0.1 x 10⁻⁶ |
| Stainless Invar: | 0.1 x 10⁻⁶ |
| Kovar: | 5 x 10⁻⁶ |
| quartz glass: | 0.5 x 10⁻⁶ |
| borosilicate glass: | 5 x 10⁻⁶ |
| soda-lime glass: | 8 x 10⁻⁶ |
| silicon carbide: | 4 x 10⁻⁶ |
| silicon nitride: | 3 x 10⁻⁶ |
| boron nitride | 1 x 10⁻⁶ |
| aluminum nitride: | 5 x 10⁻⁶ |
| aluminum oxide: | 6 x 10⁻⁶ |
| aluminum: | 24 x 10⁻⁶ |
| SUS304: | 17 x 10⁻⁶ |

With reference to the pellicle 10 shown in Fig. 1, the adhesive 2 for adhering the pellicle membrane 1 to the pellicle frame 3 and the agglutinant 4 for adhering the pellicle frame 3 to the photomask 5 may be made of any materials known to have been conventionally adopted. For example, it is even possible to use a solvent for the adhesive 2 to adhere the pellicle membrane 1 to the pellicle frame 3, namely by first putting the solvent, which dissolves the pellicle frame material well, to the pellicle frame 3, and attaching the pellicle membrane to the solvent, and then drying the solvent with blown air; or it is good to use an adhesive such as acrylic resin, silicone resin, epoxy resin or the like for the adhesive 2. It is however preferable that in the case of the EUV exposure operation, the adhesive 2 is made of a material having low outgassing tendency.

As for the agglutinant 4, which adheres the pellicle frame 3 to the photomask 5, it is possible to use materials such as polybutene resin, polyvinyl acetate, SEBS (poly styrene-ethylene-butadiene-styrene) resin, acrylic resin, or silicone resin; of these acrylic resin and silicone resin are especially preferable.

The formation of the layers of the adhesive 2 and the agglutinant 3 may be carried out by a method such as dipping, spraying, brushing or by means of an application machine equipped with a dispenser; of these alternatives, use of the application machine with dispenser is the most preferably for the reasons of stability, workability, yield, etc.

When the viscosity of the adhesive 2 or the agglutinant 4 is so high that it is difficult to conduct smooth application of the glue by means of the application apparatus, it is possible, as need be, to add to it an aromatic solvent such as toluene or xylene, or an aliphatic solvent such as hexane, octane, iso-octane, or iso-paraffine, or a ketone-based solvent such as methyl ethyl ketone or methyl isobutyl ketone, or an ester-based solvent such as ethyl acetate or butyl acetate, or an ether-based solvent such as di-isopropyl ether or 1,4-dioxane, or a mixture of two or more of these.

### [Examples]

Next, we will explain the present invention concretely by using examples and comparative examples, but the scope of the invention is not limited thereby.

### [Example 1]

At first, a rectangular pellicle frame made of Invar, which is an alloy of iron and nickel [Fe-Ni36; linear expansion coefficient: 1 x 10⁻⁶ (1/K)], of which the outer periphery measured 149 mm x 122 mm x 5.8 mm (in height) and the thickness 2 mm, was transported into a clean room, where it was washed with a neutral detergent and pure water thoroughly and dried.

Next, an agglutinant agent X-40-3122 (a product manufactured by Shin-Etsu Chemical Co., Ltd.) as the photomask-bonding agglutinant was applied to the lower annular face of the pellicle frame, and the agglutinant was dried in the air blow until it lost fluidity; then the pellicle frame was heated to 130 degrees C, whereby the agglutinant was completely hardened.

Also, a silicone-based adhesive KE-101A/B (a product manufactured by Shin-Etsu Chemical Co., Ltd.), which has a low outgassing tendency, was applied to the upper annular face of the pellicle frame, and a pellicle membrane made of single crystal silicon was adhered to the upper annular face of the pellicle frame via the adhesive. That portion of the pellicle membrane of single crystal silicon which extended beyond the outer edges of the pellicle frame was trimmed off with a cutter, whereupon a pellicle was completed.

### [Example 2]

Except that, in place of the pellicle frame made of Invar, a pellicle made of Super Invar [Fe-Ni32-Co5; linear expansion coefficient: 0.1 x 10⁻⁶ (1/K)], which is an alloy consisting of iron, nickel and cobalt, was used, a pellicle was manufactured in the same manner as in Example 1.

### [Example 3]

Except that, in place of the pellicle frame made of Invar, a pellicle made of quartz glass [SiO₂; linear expansion coefficient: 0.5 x 10⁻⁶ (1/K)] was used, a pellicle was manufactured in the same manner as in Example 1.

### [Example 4]

Except that, in place of the pellicle frame made of Invar, a pellicle made of aluminum oxide [Al₂O₃; linear expansion coefficient: 6 x 10⁻⁶ (1/K)] was used, a pellicle was manufactured in the same manner as in Example 1.

### [Comparative Example 1]

Except that, in place of the pellicle frame made of Invar, a pellicle made of an aluminum alloy of Al-Zn-Mg-Cu composition [JIS A7075; linear expansion coefficient: 23.4 x 10⁻⁶ (1/K)] was used, a pellicle was manufactured in the same manner as in

### Example 1.

### [Comparative Example 2]

Except that, in place of the pellicle frame made of Invar, a pellicle made of a stainless steel [SUS304; linear expansion coefficient: 17 x 10⁻⁶ (1/K)] was used, a pellicle was manufactured in the same manner as in Example 1.

Next, the pellicles manufactured in Examples 1 through 4 and Comparative Examples 1 and 2 were subjected to a heat cycle test described below for their evaluation.

### [Heat cycle test]

The pellicles manufactured in Examples 1 through 4 and Comparative Examples 1 and 2 were individually adhered to a quartz base plate, and were let to sit in an oven at a temperature of 200 degrees C for 24 hours; then they were let to sit at room temperature for another 24 hours; this heat cycle was repeated for 5 times (heat cycle test); thereafter the appearance of the pellicles (especially the pellicle membranes) were visually inspected. Also, the flatness of the pellicles against the quartz base plate after the heat cycle test was measured with FLatMaster (a product of SOL Co., Ltd.); the measurement results were rated according to the estimation standards described below. The rated estimations are shown in Table 1.

### [Estimation standards]

### (Flatness of pellicle after heat cycle test)

Good: flatness of the pellicle after the heat cycle test was 15 micrometers or smaller.

Bad: flatness of the pellicle after the heat cycle test was greater than 15 micrometers.

### [Overall estimation]

Good: after the heat cycle, the appearance of the pellicle was good and the flatness of the pellicle was 15 micrometers or smaller.

Bad: after the heat cycle, the appearance of the pellicle was bad and the flatness of the pellicle was greater than 15 micrometers.

**[Table 1]**

| | Appearance of Pellicle after heat cycle test | Flatness of pellicle after heat cycle test | Overall Estimation |
|---|---|---|---|
| Example 1 | Good | 3.4 µm (Good) | Good |
| Example 2 | Good | 7.2 µm (Good) | Good |
| Example 3 | Good | 5.5 µm (Good) | Good |
| Example 4 | Good | 8.2 µm (Good) | Good |
| Comparative Example 1 | Bad (pellicle membrane broken) | 30.1 µm (Bad) | Bad |
| Comparative Example 2 | Bad (pellicle membrane broken) | 24.0 µm (Bad) | Bad |

As shown by the results entered in Table 1, in the cases of Examples 1 through 4, both the appearance and the flatness of the respective pellicle after the heat cycle test were good.

On the other hand, in the cases of Comparative Examples 1 and 2, after the heat cycle test, there was breakage in the pellicle membrane and the flatness of the pellicle was found degraded. It was confirmed that the pellicle frames in the cases of Comparative Examples 1 and 2 underwent such substantial expansion and contraction during the heat cycle test that the integrity of the pellicle membrane and the flatness of the pellicle were badly affected.

From the results, it was therefore found that the pellicle frames used in Examples 1 through 4 are excellent in stability against heat cycle and hence do not impart ill effects to the pellicle membrane and photomask base plate even when they are subjected to strenuous temperature change between a high temperature and a low temperature repeatedly; consequently, it was confirmed that the pellicle frame of the present invention is most suitable for use with the EUV exposure technology from overall viewpoint.

### [Representation of reference numerals]

- 1:: pellicle membrane
- 2:: adhesive
- 3:: pellicle frame
- 4:: agglutinant
- 5:: photomask
- 6:: air pressure adjustment hole
- 7:: dust stopper filter
- 10:: pellicle

## Claims

1. An EUV pellicle frame consisting of a material having a linear expansion coefficient of 10 x 10⁻⁶ (1/K) or smaller.

2. The EUV pellicle frame as claimed in Claim 1 wherein said material is a metal.

3. The EUV pellicle frame as claimed in Claim 2 wherein said metal is selected from Fe-Ni alloy, Fe-Ni-Co alloy, Fe-Ni-Co-Cr alloy, and Fe-Co-Cr alloy.

4. The EUV pellicle frame as claimed in Claim 2 wherein said metal is selected from Invar, Super Invar, Stainless Invar, and Kovar.

5. The EUV pellicle frame as claimed in Claim 1 wherein said material is a glass.

6. The EUV pellicle frame as claimed in Claim 5 wherein said glass is selected from quartz glass, borosilicate glass, soda-lime glass, aluminoborosilicate glass, aluminosilicate glass, and crystallized glass.

7. The EUV pellicle frame as claimed in Claim 1 wherein said material is a ceramics.

8. The EUV pellicle frame as claimed in Claim 7 wherein said ceramics is selected from aluminum oxide, silicon carbide, silicon nitride, aluminum nitride, and boron nitride.

9. An EUV pellicle comprising a pellicle frame, a pellicle membrane, and an adhesive for bonding said pellicle frame to said pellicle frame, wherein said pellicle frame consists of a material having a linear expansion coefficient of 10 x 10⁻⁶ (1/K) or smaller.

10. The EUV pellicle as claimed in Claim 9, wherein said material consists of a metal, glass, or ceramics.

11. The EUV pellicle as claimed in Claim 10, wherein said material consists of a metal selected from Fe-Ni alloy, Fe-Ni-Co alloy, Fe-Ni-Co-Cr alloy, and Fe-Co-Cr alloy.

12. The EUV pellicle as claimed in Claim 10, wherein said metal is selected from Invar, Super Invar, Stainless Invar, and Kovar.

13. The EUV pellicle as claimed in Claim 10, wherein said material is a glass selected from quartz glass, borosilicate glass, soda-lime glass, aluminoborosilicate glass, aluminosilicate glass, and crystallized glass.

14. The EUV pellicle as claimed in Claim 10, wherein said material is a ceramics selected from aluminum oxide, silicon carbide, silicon nitride, aluminum nitride, and boron nitride.
